**Europäisches Patentamt**

**European Patent Office**

**Office européen des brevets**

(19)

(11) Veröffentlichungsnummer: **0 012 792**
**B1**

# (12) EUROPÄISCHE PATENTSCHRIFT

(45) Veröffentlichungstag der Patentschrift:
**23.02.83**

(21) Anmeldenummer: **79103062.0**

(22) Anmeldetag: **21.08.79**

(51) Int. Cl.³: **H 03 K 3/38,** H 03 F 19/00,
H 01 L 39/22

(54) **Digitaler Stromverstärker mit Josephson Kontakten.**

(30) Priorität: **29.12.78 US 974652**

(43) Veröffentlichungstag der Anmeldung:
**09.07.80 Patentblatt 80/14**

(45) Bekanntmachung des Hinweises auf die Patenterteilung:
**23.02.83 Patentblatt 83/8**

(84) Benannte Vertragsstaaten:
**CH DE FR GB**

(56) Entgegenhaltungen:
FR-A-2 212 694
FR-A-2 396 458

**IBM TECHNICAL DISCLOSURE BULLETIN Band 16,
Heft 9, Februar 1974, New York F. FANG et al. «Self-
resetting scheme for terminated Jospehson junction circuits» Seiten 3068 bis 3069**

(73) Patentinhaber: **International Business Machines
Corporation, Armonk, N.Y. 10504 (US)**

(72) Erfinder: **Faris, Sadeg Mustafa, 2316 Mark Road,
Yorktown Heights New York 10598 (US)**

(74) Vertreter: **Schröder, Otto H., Dr.-Ing., c/o International
Business Machines Corporation Zurich Patent
Operations Säumerstrasse 4, CH-8803 Rüschlikon/ZH
(CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Digitaler Stromverstärker mit Josephson Kontakten

Die Erfindung betrifft einen digitalen Stromverstärker mit Josephson Kontakten, die so betrieben werden können, dass sie selbst rückstellen. Die Vorrichtung arbeitet im supraleitfähigen Zustand, z.B. bei der Temperatur flüssigen Heliums. Die benützten Josephson Kontakte können die Form von Mehrkontaktinterferometern haben, wie sie sowohl in logischen als auch in Speicherschaltungen als Schaltelemente verwendet werden.

Stromverstärker mit Josephson Kontakten, bei welchen ein in bestimmten Pfaden fliessender Strom in einen Arbeitskreis abgelenkt wird, sind bereits bekannt. Eine derartige Schaltung ist im IBM Technical Disclosure Bulletin, Band 20, Nr. 5, Oktober 1977, Seite 2031 publiziert. In der dort gezeigten Schaltung wird eine einzelne Stromquelle benützt, die die Summe aller Gate-Ströme in mehreren parallel liegenden Zweigen liefert. Der angelegte Strom verteilt sich auf die verschiedenen Zweige gemäss deren individuellem Widerstand. In jedem Zweig liegt auch ein Josephson Kontakt. Der Josephson Kontakt des ersten Zweiges wird durch einen Steuerstrom geschaltet, wogegen die Kontakte der übrigen Zweige schalten, wenn ihr Schwellwert überschritten wird. Wenn der erste Josephson Kontakt geschaltet wird, wird Strom in den nächsten Zweig abgelenkt, dessen Strom zusammen mit dem abgelenkten Strom den dort liegenden Kontakt veranlasst zu schalten. Das Schalten dieses zweiten Kontaktes veranlasst wiederum den Kontakt im nächstfolgenden Zweig zu schalten, usw., bis schliesslich alle Zweigströme abgelenkt sind und durch eine Belastungsleitung fliessen. Die Arbeitsweise dieser Art von Verstärker beruht auf einer vollständigen Übertragung der Gate-Ströme auf eine Last.

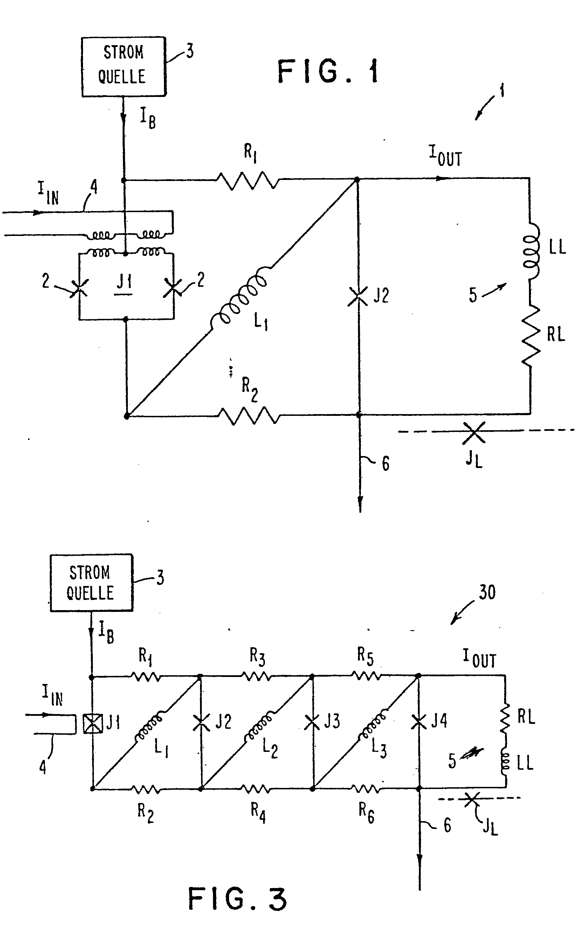

In IBM Technical Disclosure Bulletin, Band 17, Nr. 10, März 1975, Seite 3082, wird in Fig. 1 ein Paar von Josephson Kontakten gezeigt, dessen einer elektromagnetisch gesteuert wird und von einer Induktivität sowie einem Widerstand überbrückt ist. In dieser Hinsicht gleicht die abgebildete Schaltung oberflächlich der nachfolgend dargestellten. Die Arbeitsweise ist jedoch völlig verschieden, da die Schaltung bei genauer Betrachtung einen ohmisch-induktiven Zweig und nicht eine reine Induktivität aufweist, wie sie in der vorliegenden Anwendung als Stromquelle auftritt, wenn ein vorhergehender Josephson Kontakt schaltet. In der Schaltung der vorliegenden Anwendung liefert eine einzelne Stromquelle eine Einheit des Gate-Stromes, der im Ruhestand durch alle Josephson Kontakte und die dazugehörigen Induktivitäten fliesst. Dies wird um so mehr klar, wenn man berücksichtigt, dass im Ruhezustand eine Reihenschaltung aller Josephson Kontakte und aller Induktivitäten vorliegt. Die Umschaltung irgend eines Josephson Kontaktes schaltet praktisch eine Induktivität parallel zum Gate-Strom, so dass die Summe zweier Ströme dem nachfolgenden Josephson Kontakt zugeleitet wird. Die so erreichte Verstärkung des Eingangssignals ist eine Funktion der Anzahl der Induktivitäten, welche eine nach der anderen mit der Stromquelle parallel geschaltet werden. Nachdem der Impuls an die Last abgegeben wurde, wird der gesamte Schaltkreis von selbst rückgestellt, entweder in Abhängigkeit von der Lastimpedanz oder unabhängig von derselben.

Demgemäss ist es ein hauptsächliches Ziel der vorliegenden Erfindung, einen digitalen Verstärkerkreis anzugeben, der eine hohe Verstärkung aufweist. Es ist ein weiteres Ziel der Erfindung, eine digitale Verstärkerschaltung anzugeben, die nur eine einzige Stromversorgung benötigt. Darüber hinaus ist es ein Ziel der Erfindung, einen solchen Verstärker anzugeben, der selbst-rückstellend ist. Dabei soll diese letztere Eigenschaft abhängig oder unabhängig von der Lastimpedanz sein. Schliesslich ist es Ziel der Erfindung, eine selbst-rückstellende Verstärkerschaltung aufzuzeigen, die eine hohe Lastimpedanz aufweist.

Diese Ziele werden verwirklicht durch den vorliegenden Verstärker mit wenigstens einer Stromquelle, einem Belastungskreis und wenigstens einer Induktivität, die über im Ruhezustand im span-nungslosen Zustand befindliche supraleitende Jo-sephson Kontakte mit der Stromquelle in Reihe geschaltet ist, und die dadurch gekennzeichnet ist, dass die Josephson Kontakte auf ein Eingangssignal hin den Strom durch die Induktivität unterbrechen, so dass er durch den Belastungskreis geleitet wird, und die Induktivität dem Belastungskreis parallel schalten.

Der vorliegende digitale Stromverstärker benützt Josephson Kontakte, welche im supraleitenden Zustand arbeiten. Die vorgezogene Ausführungsart weist ein Paar Josephson Kontakte auf, die über Widerstände verbunden und mit einer Ausgangslast parallel geschaltet sind. Der erste Kontakt kann durch das Zusammenwirken eines Gate-Stroms und eines Steuerstroms geschaltet werden. Der zweite Kontakt wird durch das Zusammenwirken des Gate-Stroms und eines Stroms geschaltet, der von einer Induktivität geliefert wird, welche zwischen die eine Elektrode eines Kontaktes und die andere Elektrode des nächsten Kontaktes geschaltet ist. Im Ruhezustand liefert die Schaltung einen Strompfad von einer Gleichstromquelle durch den ersten Josephson Kontakt, die Induktivität, den zweiten Josephson Kontakt und zurück zur gleichen Stromquelle. Die Widerstände bilden im Ruhezustand eine hohe Impedanz für den Gate-Strom. Schaltet der erste Josephson Kontakt, welcher vorzugsweise als Interferometer ausgebildet ist, so wird der Gate-Strom auf den nächsten Josephson Kontakt abgelenkt. Die Induktivität erfährt dabei eine hohe Stromänderung, ohne dass der gespeicherte magnetische Fluss wesentlich ändert. Der in der Induktivität dadurch erzeugte Strom fliesst zusammen mit dem abgelenkten Gate-Strom durch den zweiten Josephson Kontakt. Die Summe dieser Ströme überschreitet den Schwellwert des zweiten Josephson Kontaktes und veranlasst diesen umzuschalten und den gesamten Strom auf die Last zu leiten. Der Lastkreis kann eine hohe Impedanz aufweisen. Unabhängig von dieser Impedanz sind die Josephson Kontakte selbst-rückstellend. Der Lastkreis kann aber auch eine niedere Impedanz aufweisen und dadurch einen Einfluss auf das Rückstellen der Josephson Kontakte ausüben. Andererseits können die Widerstände einen Einfluss auf die Rückstellung ausüben, solange die Schaltung in einem dynamischen Zustand ist. Mehrere Stufen können dem Lastkreis in Kaskade vorgeschaltet sein, wobei der erreichte Verstärkungsfaktor eine Funktion der Anzahl von Induktivitäten ist. Der Verstärkungsfaktor ist der Anzahl der Induktivitäten proportional. Die Verlustleistung ist äusserst gering.

Nachfolgend wird die Erfindung anhand von in den Zeichnungen dargestellten Ausführungsbeispielen im einzelnen erklärt.

Fig. 1 ist das Schaltbild des vorliegenden Verstärkers, der einen Stromimpuls hoher Amplitude von wenigen Picosekunden Dauer liefern kann.

Fig. 2 ist die graphische Darstellung des Stromes als Funktion der Zeit. Der Ruhezustand sowie der Ablauf des Schaltvorganges ist dargestellt.

Fig. 3 zeigt die Kaskadenschaltung mehrerer Stufen gemäss Fig. 1 zur Erreichung einer höheren Verstärkung respektive eines grösseren Stromes.

Fig. 4 zeigt die Parallelschaltung mehrerer Anordnungen gemäss Fig. 3 auf eine gemeinsame Last, derart, dass die Summe mehrerer Ströme gleichzeitig an die Last geliefert werden kann. Die Schaltungen können gleichzeitig oder hintereinander betätigt werden. Durch Vorgabe entsprechender Stromrichtung und zeitlicher Abstimmung können extrem kurze Pulse erzeugt werden. Zusätzlich können logische Funktionen wie UND, ODER etc. ausgeführt werden.

Fig. 1 zeigt die schematische Darstellung eines selbst-rückstellenden digitalen Stromverstärkers 1, der an einer Ausgangsklemme einen Impuls hohen Stromes und extrem kurzer Dauer liefert. Der Stromverstärker 1 besteht aus einem Interferometer J1, welches einen Josephson-Strom führt. Das Interferometer J1 ist eine symmetrisch gespeiste Zweikontaktvorrichtung bekannter Art. Die Kontakte des Interferometers J1 in Fig. 1 sind mit 2 bezeichnet. Anstelle des Interferometers kann an sich auch eine andere Vorrichtung, die Josephson-Strom führt, benützt werden. Das Interferometer ist jedoch vorzüglich geeignet aus Gründen der Grösse und auch der Verstärkung. Das Interferometer J1 ist mit einer Stromquelle 3 in Reihe geschaltet. Die Stromquelle liefert den Strom $I_B$ als Gate-Strom für das Interferometer. Einer Steuerleitung 4, die mit dem Interferometer magnetisch gekoppelt ist, kann ein Steuerstrom $I_{IN}$ zugeführt werden, der den Schwellwert $I_0$ des Interferometers herabsetzt und es so veranlasst, vom spannungslosen Zustand in des Spannungszustand umzuschalten, wenn der Steuerstrom in Leitung 4 auftritt.

Fig. 1 zeigt einen weiteren Josephson Kontakt J2. J2 kann ebenfalls eine beliebige Einrichtung sein, die Josephson-Strom führt und die vom spannungslosen Zustand in den Spannungszustand schaltet, wenn der sie durchfliessende Strom einen Schwellwert $I_0$ überschreitet. Zwischen J1 und J2 ist eine Induktivität $L_1$ angeordnet, die mit diesen Josephson Kontakten eine Reihenschaltung bildet. Ein Widerstand $R_1$ überbrückt Kontakt J1 und die Induktivität $L_1$, ein Widerstand $R_2$ den Kontakt J2 und $L_1$. Wie noch gezeigt wird, schliesst im Ruhezustand die Induktivität $L_1$ die Widerstände $R_1$ und $R_2$ kurz. Ein Laststromkreis 5, der aus einem Widerstand RL und einer dazu in Reihe geschalteten Induktivität LL besteht, ist dem Kontakt J2 parallel geschaltet und wird vom Strom $I_{OUT}$ durchflossen, wenn die Schaltung 1 betätigt wird. Die Verbindung 6 schliesst im Ruhezustand den Stromkreis, der aus der Stromquelle 3, dem Interferometer J1, der Induktivität $L_1$ und dem Kontakt J2 besteht.

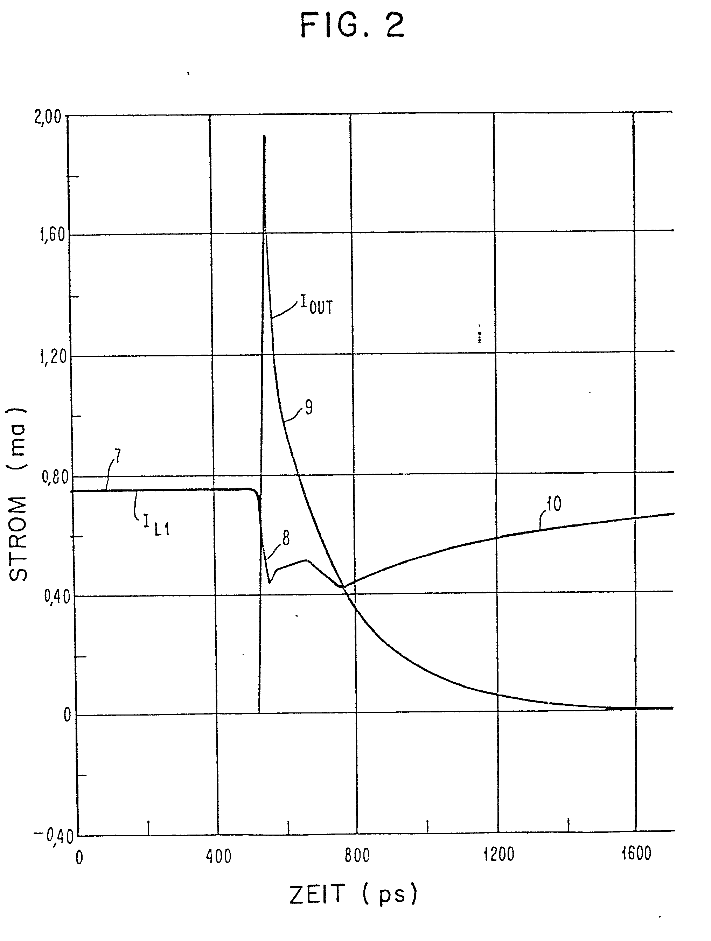

Fig. 2 zeigt die graphische Darstellung des Stromes in der Induktivität $L_1$ und des Ausgangsstromes $I_{OUT}$ in dem den Vorrichtungen J1 und J2 nachgeschalteten Belastungswiderstand als Fuktion der Zeit. Im Ruhestand fliesst der Gate-Strom $I_B$ von der Stromquelle 3 zum Interferometer J1. Der Gate-Strom $I_B$ reicht nicht aus, um das Interferometer J1 zu schalten und fliesst, da der Weg über den Widerstand $R_1$ erschwert ist, über die Induktivität. Hier sei daran erinnert, dass Josephson Kontakte die bei der Temperatur flüssigen Heliums, d.h. bei 4,2° Kelvin, arbeiten, in einem Zustand einen Tunnelstrom ohne Spannungsabfall und im anderen Zustand einen Tunnelstrom mit Spannungsabfall zulassen. Die Zustände werden als spannungslos und als Spannungszustand bezeichnet. Der Strom $I_B$ fliesst, wie gesagt, durch das Interferometer J1 und trifft dann auf Widerstand $R_2$, welcher den Stromfluss ebenfalls stärker behindert als die Induktivität $L_1$. Der Strom $I_B$ wird daher durch die Induktivität $L_1$ und darauf über den Josephson Kontakt J2 und die Rückleitung 6 zur Stromquelle 3 zurückfliessen. Der Josephson Kontakt J2, der sich im spannungslosen Zustand befindet, bleibt in diesem Zustand, da sein Schwellwert vom Gate-Strom $I_B$ nicht überschritten wird. Der Strom wird über den Josephson Kontakt J2 und nicht über den Belastungswiderstand 5 fliessen, da der Kontakt im spannungsfreien Zustand praktisch einen Kurzschluss darstellt. Es fliesst zu dieser Zeit also kein Strom im Lastkreis 5 und der konstante Strom bei 7 in Fig. 2, der mit $I_{L1}$ bezeichnet ist, fliesst durch das Interferometer J1, die Induktivität $L_1$, den Kontakt J2 und die Rückleitung 6. Der Strom $I_{L1}$ ist zu dieser Zeit gleich dem Gate-Strom $I_B$.

Der Verstärker 1 kann einen Ausgangsimpuls hoher Amplitude an den Lastkresi 5 abgeben, wenn ein Steuerstrom $I_{IN}$ an die Steuerleitung 4 der Fig. 1 angelegt wird. Der Steuerstrom $I_{IN}$ setzt durch sein Magnetfeld den Schwellwert des Interferometers J1 herunter, welches in den Spannungszustand schaltet und so einen höheren Widerstand für den Gate-Strom $I_B$ darstellt, als der

Widerstand $R_1$. $I_b$ wird dadurch auf den Widerstand $R_1$ umgeleitet und fliesst über diesen zum Josephson Kontakt J2 und über die Leitung 6 zurück zur Stromquelle 3. Die Umschaltung bewirkt, dass der Strom durch die Induktivität $L_1$ unterbrochen wird, worauf diese einen zusätzlichen Stromstoss an den Kontakt J2 abgibt. Der Teil 8 der $I_{L1}$ Kurve in Fig. 2 zeigt die Stromänderung in der Induktivität $L_1$. Der Strom, der die Summe des Gate-Stromes $I_B$ und des induktiv erzeugten Stromstosses von $L_1$ ist, fliesst über den Kontakt J2, wodurch dessen Schwellwert für kurze Zeit überschritten wird. Der Kontakt J2 schaltet daher ebenfalls in den Spannungszustand, wodurch der über ihn fliessende Strom als $I_{OUT}$ in den Belastungskreis 5 abgelenkt wird. Der zeitliche Verlauf dieses Stromes ist ebenfalls in Fig. 2 dargestellt. Es ist zu erkennen, dass dieser Ausgangsstromimpuls ausserordentlich kurz ist.

Wenn die Änderung des Stromes in der Induktivität $L_1$ auftritt, die in Fig. 2 bei 8 angegeben ist, schickt die Induktivität als Quelle einen Strom durch $L_1$, J2 und $R_2$. Nachdem J2 in den Spannungszustand geschaltet ist, fliesst der Strom durch den Belastungskreis 5 und fällt ab mit der Zeitkonstante L/R, die eine Fuktion der Werte der Elemente LL und RL des Belastungskreises ist. Der Stromimpuls $I_{OUT}$ hat eine ausserordentlich kurze Anstiegszeit und erreicht eine Amplitude, die von den Eigenschaften des Kreises abhängt, aber ohne weiteres mehr als doppelt so hoch sein kann als die Amplitude des Stromes, der im Ruhezustand den Verstärker 1 durchfliesst. Die Schaltung ist daher ideal für digitale Anwendungen, die einen Impuls hohen Stromes zur Auslösung nachfolgender Schaltkreise benötigen. Beispielsweise kann das magnetische Feld des Stromes $I_{OUT}$ im Belastungskreis 5 benützt werden, um eine weitere Josephson Vorrichtung $J_L$ zu schalten, die in Fig. 1 an die Leitung angekoppelt ist. Durch den Kontakt $J_L$ fliesst in einem nicht dargestellten Kreis ein eigener Gate-Strom. In Fig. 2 zeigt die Stelle 10 der Kurve $I_{L1}$, dass der Schaltkreis 1 der Fig. 1 relativ rasch in den Ruhestand zurückkehrt, weshalb ohne weiteres hohe Wiederholungsfrequenzen erreicht werden können.

Diese Rückstellung der Elemente J1 und J2 in den spannungsfreien Zustand kann eine Funktion der Widerstände $R_1$ und $R_2$ oder des Widerstandes RL sein. Wenn der Gate-Strom $I_B$ durch das Umschalten des Elementes $J_1$ auf den Widerstand $R_1$ geleitet wird und wenn der entstehende Spannungsabfall geringer als der minimale Spannungsabfall $V_{min}$ ist, schaltet das Element J1 in seinen spannungslosen Zustand zurück und führt wieder Gate-Strom, so dass der Strom $I_{L1}$ wieder aus der Stromquelle 3 zum Element J1, der Induktivität $L_1$, dem Element J2 und der Rückleitung 6 fliesst. Auf ähnliche Weise kann das Element J2 in den spannungslosen Zustand zurückgestellt werden, wenn der Spannungsabfall im Widerstand $R_2$ geringer ist als die minimale Spannung $V_{min}$ des Elementes J2. Unter diesen Bedingungen ist die Rückstellung der Elemente J1 und J2 unabhängig vom Wert des Belastungswiderstandes RL. Dabei kann ein Strom an eine hohe Ausgangsimpedanz geliefert werden, obwohl die Josephson Elemente der Schaltung selbst-rückstellend sind. Diese Eigenschaft der Schaltung 1 in Fig. 1 ist besonders erstrebenswert, weil eine selbst-rückstellende Schaltung mit Josephson Elementen, die eine Belastung hoher Impedanz speisen kann, bisher nicht möglich war. Selbstverständlich ist das Prinzip auch anwendbar, wenn eine Belastung RL geringer Impedanz zu speisen ist. Die Spannungsabfälle über den Widerständen $R_1$ und $R_2$ können auch grösser sein als die minimale Spannung und die Schaltung kann trotzdem selbst-rückstellend sein, wenn der Spannungsabfall am Belastungswiderstand RL geringer ist als die minimale Spannung der Elemente J1 und J2. Die Induktivität LL in Fig. 1, die Lastinduktivität im Ausgangskreis 5, kann die Gate-Leitung eines nachfolgenden Josephson Elementes sein. Wie schon erwähnt, arbeitet die Verstärkerschaltung 1 der Fig. 1 bei der Temperatur flüssigen Heliums, d.h. bei 4,2° Kelvin, und die Schaltung, mit Ausnahme der Widerstände, besteht aus Materialien, die bei dieser Temperatur supraleitfähig sind.

Damit der in Fig. 2 dargestellte Signalverlauf erreicht wird, haben die Elemente der Fig. 1 folgende Werte:

$$
\begin{aligned}
I_B &= 0{,}75 \ \text{mA} \\
I_{IN} &= 0{,}75 \ \text{mA} \\
I_O &= 0{,}5 \quad \text{mA} \\
&\quad (\text{für jeden Kontakt 2}) \\
I_O &= 1 \qquad \text{mA (von J2)} \\
R_1 &= R_2 = 0{,}4 \ \text{Ohm} \\
RL &= 0{,}10 \ \text{Ohm} \\
L_1 &= 150\text{pH} \\
L_L &= 20\text{pH}
\end{aligned}
$$

Die Zweiginduktivitäten des Interferometers J1 betragen 0,5pH.

Die bisher beschriebene Schaltung ist im übrigen selbst-rückstellend, weil sie nur eine externe Quelle aufweist. Die Schaltung hat eine Verstärkung V, die proportional der Zahl der stromspeichernden Induktivitäten $L_1$ ist. Bei den oben angegebenen Parametern beträgt die Verstärkung V=2,6, wenn die Zahl der stromspeichernden Elemente gleich 1 ist. Die Verstärkung ist grösser als 2 infolge unterkritisch gedämpfter Stromübertragung auf die Last.

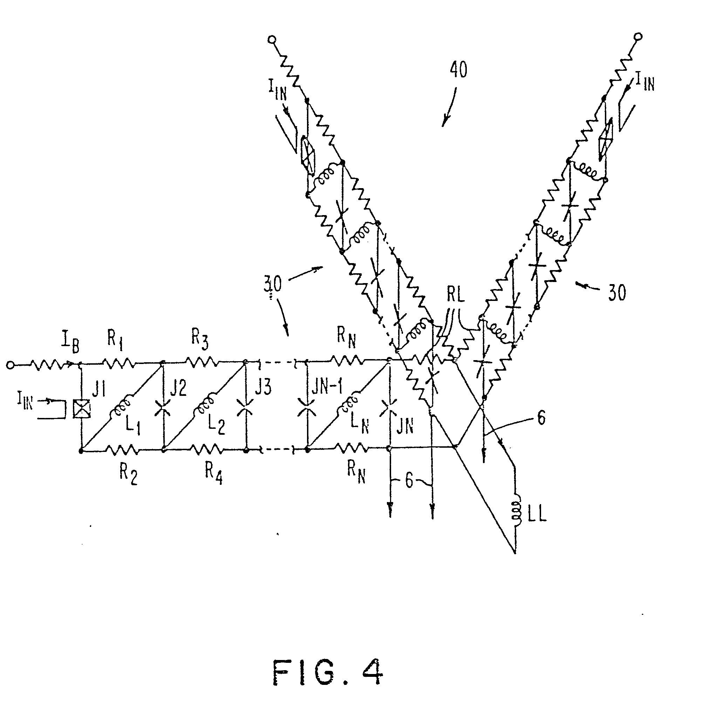

Die Schaltung 30 in Fig. 3 gleicht der der Fig. 1, weist jedoch mehrere Induktivitäten $L_1$–$L_3$ auf, welche mit den Josephson Elementen J2 – J4 in Kaskade geschaltet sind. Die Verstärkung V des Schaltkreises wird gleich der des Kreises von Fig. 1 mal der Anzahl n von Induktivitäten. Wo die Elemente der Fig. 3 denen der Fig. 1 entsprechen sind sie mit gleichen Buchstaben bezeichnet. Die Widerstände $R_3$ und $R_5$ der Fig. 3 entsprechen dem Widerstand $R_1$, die Widerstände $R_4$ und $R_6$ dem Widerstand $R_2$. Die Elemente J3 und J4 enstprechen dem Element J2. Ebenso entsprechen die Induktivitäten $L_2$ und $L_3$ der Induktivität $L_1$. Der Lastkreis 5 ist derselbe wie der Lastkreis 5 der Fig.1.

Die Schaltung 30 arbeitet genau gleich wie die Schaltung 1. Wenn jedoch das Element J2 schaltet, liefert es einen Strom nicht an den Belastungskreis 5 sondern an des Element J3. Dieses schaltet um, wenn die Induktivität L2 als Stromquelle wirkt. Wenn das Element J3 schaltet, fliesst der gesamte ihm zufliessende Strom zusammen mit dem Strom aus der Induktivität $L_3$ an das Element J4. Wenn schliesslich das Element J4 schaltet, liefert es einen Strom $I_{OUT}$ an die Last RL, der dreimal so gross ist, als wenn eine einzelne Induktivität im Schaltkreis benutzt wird. Die Induktivitäten und die Josephson Elemente können beliebig in Kaskade geschaltet werden um Stromimpulse von ausserordentlicher Grösse zu erzeugen. Die Elemente J3 und J4 können dieselbe Schwellwertspannung haben wie das Element J2, da im Ruhezustand der maximale durch diese Elemente fliessende Strom der Gate-Strom $I_B$ ist.

Fig. 4 zeigt schematisch eine Schaltung 40, die mehrere Kreise 30, wie sie Fig. 3 zeigt, enthält. Diese Kreise sind parallel auf eine gemeinsame Last LL geschaltet. Nur ein Kreis 30 wurde beschriftet, um die Funktion der Elemente klarzustellen. Die verschiedenen Kreise sind identisch, so dass, wenn jedes Element J1 gleichzeitig einen Eingangsimpuls $I_{IN}$ über die Steuerleitung 4 erhält, ein Ausgangssignal an die Belastung 5 geliefert wird, das der Summe der Ausgangssignale aller Schaltkreise 30 entspricht. Die Arbeitsweise wurde im einzelnen bereits im Bezug auf Fig 1 dargelegt. Mit einer derartigen Schaltung können extrem starke Ströme an eine Last abgegeben werden und starke magnetische Felder erzeugt werden, z.B. zur Fokussierung von Elektronenstrahlen, zur Kernfusion, etc. Da die Schaltkreise 30 einzeln ausgelöst werden, können die Übertragungsverzögerungen in Rechnung gesetzt und durch zeitliche Verschiebung der Auslösesignale an den Elementen J1 kompensiert werden. Auch können durch entsprechende Polung der Gate-Ströme $I_B$ entgegengesetzte Stromimpulse an die Last 5 abgegeben werden, wobei durch Verstellen der Auslösung der verschiedenen Kreise 30 infolge Substraktion der Ströme extrem kurze Impulse erzeugt werden können. Weiterhin ist es möglich, durch richtige Einstellung der Auslöseimpulse Ausgangsimpulse hohen Stromes mit besonders hoher Folgefrequenz zu erzeugen.

Die verwendeten Josephson Elemente sind vorzugsweise Mehrfach-Kontaktelemente, die als Josephson Interferometer bezeichnet werden. Solche Interferometer sind beispielsweise im USA Patent 3,978,351 gezeigt. Die Verbindungen zwischen den einzelnen Elementen, z.B. die Leitungen 6 und die Steuerleitung 4, werden aus supraleitfähigem Material hergestellt. In diesem Zusammenhang sei auf die USA Patente 3,758,795 und 3,849,276 verwiesen. Die Widerstände sind nicht supraleitfähig und können z.B. gemäss dem USA Patent 3,913,120 hergestellt werden.

**Patentansprüche**

1. Digitaler Stromverstärker mit Josephson Kontakten und mit wenigstens einer Stromquelle (3), einem Belastungskreis (5) und wenigstens einer Induktivität ($L_1$), die über im Ruhezustand im spannungslosen Zustand befindliche supraleitende Josephson Kontakte (J1, J2) mit der Stromquelle in Reihe geschaltet ist, gekennzeichnet dadurch, dass die Josephson Kontakte (J1, J2) auf ein Eingangssignal ($I_{IN}$) hin den Strom durch die Induktivität unterbrechen, so dass er durch den Belastungskreis geleitet wird, und die Induktivität dem Belastungskreis parallel schalten.

2. Verstärker nach Anspruch 1, dadurch gekennzeichnet, dass der Belastungskreis einen Widerstand (RL) aufweist, der so bemessen ist, dass die Josephson Kontakte selbst rückstellen.

3.Verstärker nach Anspruch 1, dadurch gekennzeichnet, dass die Stromquelle (3), ein Josephson Kontakt (J1), die Induktivität ($L_1$) und ein weiterer Josephson Kontakt (J2) in Reihe geschaltet sind, und dass Widerstände ($R_1$, $R_2$) vorgesehen sind, die je einen Josephson Kontakt und die Induktivität überbrücken (Fig. 1).

4. Verstärker nach Anspruch 3, dadurch gekennzeichnet, dass der erste, nahe der Stromquelle liegende, Josephson Kontakt (J1) durch ein Eingangssignal ($I_{IN}$) gesteuert wird (4) und dass dem zweiten Josephson Kontakt (J2) der Belastungskreis (5) parallel geschaltet ist.

5. Verstärker nach Anspruch 1, dadurch gekennzeichnet, dass mehrere Josephson Kontakte (J1–J4) und mehrere Induktivitäten ($L_1$–$L_3$ abwechselnd in Reihe geschaltet sind ($J1$–$L_1$–$J2$–$L_2$–$J_3$...), dass Widerstände ($R_1$–$R_6$) vorgesehen sind, die jeweils einen Josephson Kontakt und die nachfolgende Induktivität ($R_1$, $R_3$, $R_5$) beziehungsweise jeweils eine Induktivität und den nachfolgenden Josephson Kontakt ($R_2$, $R_4$, $R_6$) überbrücken, und dass der Lastkreis (5) zum letzten Josephson Kontakt (J4) parallel geschaltet ist. (Fig. 3).

6. Verstärker nach Anspruch 1, dadurch gekennzeichnet, dass mehrere Verstärker, je nach Anspruch 3 oder Anspruch 5, parallel auf denselben Lastkreis arbeiten (Fig. 4).

7. Verstärker nach Anspruch 3 oder Anspruch 5, dadurch gekennzeichnet, dass der Lastkreis einen weiteren Josephson Kontakt (JL) beinflusst.

**Claims**

1. Josephson-contacts digital current amplifier with at least one current source (3), a load circuit (5), and at least on inductance ($L_1$), the latter being connected in series with the current source via Josephson contacts (J1, J2) which, in the steady state, are in the zero-voltage condition, characterized in that the Josephson contacts (J1, J2), upon application of an input signal ($I_{IN}$), cause the current through the inductance to be interrupted and to be guided to the load circuit, and the inductance to be connected in parallel with the load circuit.

2. An amplifier as claimed in claim 1, characterized in that the load circuit comprises a resistor (RL) of a size that auses the Josephson contacts to be self-resetting.

3. An amplifier as claimed in claim 1, characterized in that the current sourse (3), a Josephson contact (J1), the inductance (L₁), and a further Josephson contact (J2) are serially connected, and in that resistors (R₁, R₂) are provided, each of which bridges a Josephson contact and the inductance. (Fig. 1)

4. An amplifier as claimed in claim 3, characterized in that the first Josephson contact (J1), arranged adjacent the current source, is controlled by an input signal (I_IN) and in that the second Josephson contact (J2) is connected in parallel with the load circuit (5).

5. An amplifier as claimed in claim 1, characterized in that a plurality of Josephson contacts (J1–J4) and a plurality of inductances (L₁–L₃) are alternately series connected (J1–L₁–J2–L₂–J3...), that resistors (R₁–R₆) are provided, each of which bridges either a Josephson contact and the subsequent inductance (R₁, R₃, R₅) or an inductance and the subsequent Josephson contact (R₂, R₄, R₆), and in that the load circuit (5) is connected in parallel with the last Josephson contact (J4). Fig. 3)

6. An amplifier as claimed in claim 1, characterized in that a plurality of amplifiers, each as claimed in claim 3 or claim 5, cooperate with the same load circuit. (Fig. 4)

7. An amplifier as claimed in claim 3 or claim 5, characterized in that the load circuit affects a further Josephson contact (JL).

**Revendications**

1. Amplificateur de courant numérique à contacts de Josephson comportant au moins une source de courant (3), un circuit de charge (5), et au moins une inductance (L₁), montée en série avec la source de courant à travers des contacts de Josephson, (J1, J2) qui, en régime permanent, sont dans l'état de tension nulle, caractérisé en ce que les contacts de Josephson (J1, J2) coupent le courant à travers l'inductance, suite à l'application d'un signal d'entrée (I_IN), de telle sorte qu'il passe à travers le circuit de charge et que l'inductance est mise en parallèle avec le circuit de charge.

2. Amplificateur selon la revendication 1, caractérisé en ce que le circuit de charge comporte une résistance (RL) d'une valeur telle que les contacts de Josephson sont auto-restaurés.

3. Amplificateur selon la revendication 1, caractérisé en ce que la source de courant (3), un contact de Josephson (J1), l'inductance (L₁), et un autre contact de Josephson (J2) sont montés en série, et en ce qu'on prévoit des réstistances (R₁, R₂), chacune shuntant un contact de Josephson et l'inductance (figure 1).

4. Amplificateur selon la revendication 3, caractérisé en ce que le premier contact de Josephson, (J1) situé à proximité de la source de courant, est commandé par un signal d'entrée (I_IN), et en ce que le second contact de Josephson (J2) est monté en parallèle avec le circuit de charge (5).

5. Amplificateur selon la revendication 1, caractérisé en ce que plusieurs contacts de Josephson (J1–J4) et plusieurs inductances (L₁–L₃) sont alternativement montés en série (J1–L₁–J2–L₂–J3...), en ce qu'on prévoit des résistances (R₁–R₆) qui, respectivement, shuntent un contact de Josephson et l'inductance suivante (R₁, R₃, R₅) ou une inductance et le contact de Josephson suivant R₂, R₄, R₆), et en ce que le circuit de charge (5) est monté en parallèle avec le dernier contact de Josephson (J4) (figure 3).

6. Amplificateur selon la revendication 1, caractérisé en ce que plusieurs amplificateurs fonctionnent en parallèle sur le même circuit de charge selon la revendication 3 ou la revendication 5 (figure 4).

7. Amplificateur selon la revendication 3 ou 5, caractérisé en ce que le circuit de charge influe sur un autre contact de Josephson (JL).

FIG.1

FIG.3

# FIG. 2

FIG. 4